# EUROPEAN PATENT SPECIFICATION

(11) **EP 4 481 834 B1**
(45) Date of publication and mention of the grant of the patent: **04.06.2025**
(21) Application number: 23208472.3
(22) Date of filing: 08.11.2023
(51) Int. Cl.: H10F 10/166, H10F 77/20

(54) **SOLAR CELL AND METHOD FOR PRODUCING THE SOLAR CELL**
SOLARZELLE UND VERFAHREN ZUR HERSTELLUNG DER SOLARZELLE
CELLULE SOLAIRE ET PROCÉDÉ DE FABRICATION DE LA CELLULE SOLAIRE

(30) Priority: 21.06.2023 CN 202310741576
(43) Date of publication of application: 25.12.2024
(73) Proprietor: Trina Solar Co., Ltd, Changzhou, Jiangsu 213031 (CN)
(72) Inventor: LIU, Chengfa, Changzhou, 213031 (CN); CHEN, Hong, Changzhou, 213031 (CN); CHEN, Daming, Changzhou, 213031 (CN); CHEN, Yifeng, Changzhou, 213031 (CN)
(74) Representative: Nederlandsch Octrooibureau

(56) References cited:
- CN-A- 114 784 148
- BRUHAT ELISE ET AL: "Contacting n+ Poly-Si Junctions with Fired AZO Layers: A Promising Approach for High Temperature Passivated Contact Solar Cells", 2019 IEEE 46TH PHOTOVOLTAIC SPECIALISTS CONFERENCE (PVSC), IEEE, 16 June 2019 (2019-06-16), pages 2319 - 2324, XP033703084, DOI: 10.1109/PVSC40753.2019.8980652
- KAFLE BISHAL ET AL: "TOPCon - Technology options for cost efficient industrial manufacturing", SOLAR ENERGY MATERIALS AND SOLAR CELLS, ELSEVIER SCIENCE PUBLISHERS, AMSTERDAM, NL, vol. 227, 26 April 2021 (2021-04-26), XP086564625, ISSN: 0927-0248, [retrieved on 20210426], DOI: 10.1016/J.SOLMAT.2021.111100

## Description

### Technical field

The invention relates to the field of photovoltaic, and specifically relates to a solar cell and a method for producing the solar cell.

### Background

Tunnel Oxide Passivating Contacts solar cell (TOPCon) was proposed in 2014. The solar cell includes a tunnel oxide layer and a doped polysilicon layer. The tunnel oxide layer can selectively transport carriers, and the doped polysilicon layer acts as field passivation. The electrodes of the solar cell penetrate a functional layer (such as an anti-reflection layer) located in the electrode region and contact the doped polysilicon layer.

The doped polysilicon layer in the solar cell has optical parasitic effects, which results in a decrease in the solar cell's utilization of incident light. Reducing the thickness of the doped polysilicon layer can reduce the absorption of incident light by the doped polysilicon layer, thereby improving the solar cell's utilization of incident light. However, the reduction in the thickness of the doped polysilicon layer increases the risk of the electrode burning through the polysilicon layer, which would result in contact between the electrode and the substrate. Contact between the electrode and the substrate will cause the recombination current density to increase, which will seriously affect the efficiency of the solar cell. CN 114784148 A describes a preparation method of a solar cell, the solar cell and a photovoltaic module.

Therefore, how to balance the advantage of increasing the utilization rate of incident light with the disadvantage of the increased risk of the electrode burning through the doped polysilicon layer, both of which brought by the reduced thickness of the doped polysilicon layer, is a problem that needs to be solved urgently.

### Summary

Some embodiments of the present disclosure are intended to provide a solar cell and a method for producing the solar cell that can reduce the thickness of the doped polysilicon layer while preventing the electrode from burning through the doped polysilicon layer. The invention provides the solar cell according to claim 1 and the method for producing a solar cell according to claim 9.

Some embodiments provide a solar cell, comprising: a substrate having a first surface and a second surfaces opposite to each other in a first direction, the first direction is a thickness direction of the substrate; a tunnel oxide layer located on the first surface and/or the second surface; a doped polysilicon layer located on a surface of the tunnel oxide layer away from the substrate; a barrier layer located in an electrode region of the solar cell and in contact with the doped polysilicon layer, a doping type of the barrier layer is the same as the doped polysilicon layer; and an electrode located in the electrode region and in contact with the barrier layer; wherein a method of forming the barrier layer includes etching the doped polysilicon layer in the electrode region in the first direction to form a groove with a predetermined depth, and forming the barrier layer in the groove, the predetermined depth is equal to or less than a thickness of the doped polysilicon layer, a material of the barrier layer includes silicon carbide and/or zinc oxide.

In an embodiment, the barrier layer goes deep into the doped polysilicon layer to the predetermined depth in the first direction.

In an embodiment, the barrier layer is located on the surface of the tunnel oxide layer away from the substrate.

In an embodiment, a surface of the barrier layer away from the substrate is flush with a surface of the doped polysilicon layer away from the substrate, or the surface of the barrier layer away from the substrate is closer to the substrate than the surface of the doped polysilicon layer away from the substrate, or the surface of the barrier layer away from the substrate is further away the substrate than the surface of the doped polysilicon layer away from the substrate.

In an embodiment, a recombination current density of the electrode region is equal to or less than 100 fA/cm².

In an embodiment, the solar cell further comprises a dielectric layer, the dielectric layer is located on a surface of the doped polysilicon layer away from the substrate and a surface of the barrier layer away from the substrate.

In an embodiment, the electrode penetrates the dielectric layer and contacts the barrier layer.

In an embodiment, the thickness of the doped polysilicon layer is equal to or greater than 3nm, and equal to or less than 200nm.

Some embodiments further provide a method for producing a solar cell, comprising: providing a substrate having a first surface and a second surfaces opposite to each other in a first direction, the first direction is a thickness direction of the substrate; forming a tunnel oxide layer on the first surface and/or the second surface; forming a doped polysilicon layer on a surface of the tunnel oxide layer away from the substrate; forming a barrier layer in an electrode region of the solar cell, the barrier layer is in contact with the doped polysilicon layer, and a doping type of the barrier layer is the same as the doped polysilicon layer; and forming an electrode in contact with the barrier layer; wherein a method of forming the barrier layer includes etching the doped polysilicon layer in the electrode region in the first direction to form a groove with a predetermined depth, and forming the barrier layer in the groove, the predetermined depth is equal to or less than a thickness of the doped polysilicon layer, and a material of the barrier layer includes silicon carbide and/or zinc oxide.

In an embodiment, a method of forming the barrier layer includes: cleaning a surface of the doped polysilicon layer; and forming the barrier layer in the electrode region, the barrier layer is in contact with a surface of the doped polysilicon layer away from the substrate.

In an embodiment, the recombination current density of the electrode region is equal to or less than 100fA/cm².

In an embodiment, the thickness of the doped polysilicon layer is equal to or greater than 3nm, and equal to or less than 200nm.

The solar cell and the producing method thereof of the present disclosure provide the barrier layer in contact with the doped polysilicon layer in the electrode region, which reduces the risk of the electrode burning through the doped polysilicon layer. The thickness of the doped polysilicon can be further reduced, thereby reducing the absorption of incident light by the doped polysilicon layer and improving the utilization rate of incident light by the solar cell.

### Description of the drawings

In order to make the above purposes, features, and advantages of the present disclosure more obvious and more understandable, the embodiments of the present disclosure are described in detail below with reference to the accompanying drawings.
FIG. 1 is a schematic front view of a solar cell according to an embodiment of the present disclosure not forming part of the claimed invention but useful for the understanding thereof;
FIG. 2A is a schematic front view of a solar cell according to another embodiment of the present disclosure;
FIG. 2B is an enlarged view of the partial structure in FIG. 2A;
FIG. 3 is a schematic front view of a solar cell according to an embodiment of the present disclosure;
FIGs. 4A and 4B are schematic front views of a solar cell according to two embodiments of the present disclosure;
FIG. 5 is a flow chart of a method for producing a solar cell according to an embodiment of the present disclosure;
FIGs. 6 and 7 are intermediate products of a method for producing a solar cell according to different embodiments of the present disclosure.

### Reference numerals

Substrate 110, first surface 111, second surface 112, tunnel oxide layer 120, doped polysilicon layer 130, initial barrier layer 132, surface 131, barrier layer 140, bottom surface 141, top surface 142, first side surface 143. Second side 144, electrode 150, electrode region 160, dielectric layer 170, and groove 180.

### Detailed description

In order to make the above objects, features, and advantages of the present disclosure more obvious and understandable, the specific implementation modes of the present disclosure are described in detail below with reference to the accompanying drawings.

Many specific details are set forth in the following description to fully understand the present disclosure, but the present disclosure can also be implemented in other ways different from those described here, so the present disclosure is not limited by the specific embodiments disclosed below.

As shown in this disclosure and claims, words such as "a", "an", and/or "the" do not specifically refer to the singular and may include the plural unless the context clearly indicates an exception. Generally speaking, the terms "comprising" and "comprising" only imply the inclusion of clearly identified steps and elements, and these steps and elements do not constitute an exclusive list. The method or apparatus may also include other steps or elements.

In addition, it should be noted that the use of words such as "first" and "second" to define parts is only to facilitate the distinction between corresponding parts. Unless otherwise stated, the above words have no special meaning and therefore cannot be understood. To limit the scope of protection of this disclosure. In addition, although the terms used in this disclosure are selected from well-known and commonly used terms, some terms mentioned in the specification of this disclosure may be selected by the applicant based on his or her judgment, and their detailed meanings are set out herein. stated in the relevant section of the description. Furthermore, the disclosure is required to be understood not merely by the actual terms used, but also by the meaning connoted by each term.

Flowcharts are used in this disclosure to illustrate operations performed by systems according to embodiments of this disclosure. It should be understood that the preceding or following operations are not necessarily performed in exact order. Instead, the various steps can be processed in reverse order or simultaneously. At the same time, other operations may be added to these processes, or a step or steps may be removed from these processes.

The solar cell and the method of the present disclosure will be described through specific embodiments.

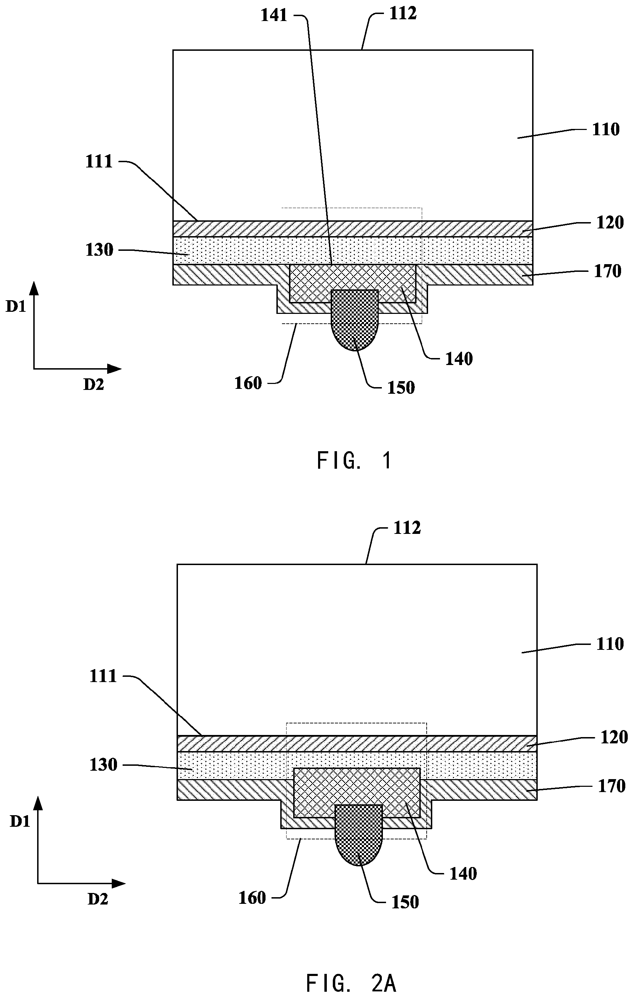

FIG. 1 is a schematic front view of a solar cell according to an embodiment not forming part of the claimed invention but useful for the understanding thereof. Referring to FIG. 1, a solar cell includes a substrate 110, a tunnel oxide layer 120, a doped polysilicon layer 130, a barrier layer 140, and an electrode 150. The substrate 110 has a first surface 111 and a second surface 112 opposite in the first direction D1 (which is also a thickness direction of the substrate 110). The first surface 111 and the second surface 112 may be polished or have a pyramid-textured topography. The tunnel oxide layer 120 is disposed on the first surface 111, and the doped polysilicon layer 130 is disposed on a surface of the tunnel oxide layer 120 away from the substrate 110 in the first direction D1. The tunnel oxide layer 120 and the doped polysilicon layer 130 together form a tunnel oxide layer-doped polysilicon layer passivation structure. It should be noted that in some other embodiments, the tunnel oxide layer 120 can also be formed on the second surface 112, or formed on both the first surface 111 and the second surface 112.

The substrate 110 may be a silicon substrate, for example, a single crystal silicon substrate or a polycrystalline silicon substrate. The substrate 110 may be doped, such as N-type doping and P-type doping. The material of the tunnel oxide layer 120 may be silicon oxide (SiOₓ), and the thickness of the tunnel oxide layer 120 may be any value from 1nm to 3nm, for example, 1nm, 1.5nm, 2nm, 2.5nm, or 3nm. The tunnel oxide layer 120 has a selective collection effect on carriers. The material of the doped polysilicon layer 130 can be selected from polysilicon, and the present disclosure does not limit the grain size of the polysilicon. The doping type of the doped polysilicon layer 130 may be the same as that of the substrate 110, or may be opposite to that of the substrate 110.

The solar cell has an electrode region, which is identified in FIG. 1 using a dashed rectangular frame 160. The electrodes of the solar cell are located in the electrode region. The electrodes are used to collect the electrical energy generated by the solar cell and transmit the electrical energy to the outside.

As shown in FIG. 1, the barrier layer 140 is disposed in the electrode region, and is in contact with the doped polysilicon layer 130. The doping type of the barrier layer 140 is the same as the doping type of the doped polysilicon layer 130. For example, the doping type of the doped polysilicon layer 130 and the doping type of the barrier layer 140 are both N-type, and the corresponding doping elements can be selected from phosphorus (P), bismuth (Bi), antimony (Sb), arsenic (As), and other V group elements. The doping type of the doped polysilicon layer 130 and the doping type of the barrier layer 140 can also be P-type, and the corresponding doping elements can be selected from one or more III group elements such as boron (B), aluminum (Al), gallium (Ga), or indium (In).

Continuing with reference to FIG. 1, the electrode 150 is in contact with the barrier layer 140. It should be understood that the number of the electrode regions and the electrodes 150 in the solar cell is not limited to the one shown in FIG. 1. The solar cell includes a certain number of electrode regions and electrodes 150 spaced apart in the second direction D2, which are not shown in FIG. 1 due to the limited size of FIG. 1.

In an embodiment, in FIG. 1, the solar cell further includes a dielectric layer 170. The dielectric layer 170 is disposed on the surface of the doped polysilicon layer 130 and the barrier layer 140 away from the substrate 110 in the first direction D1. In other words, the dielectric layer 170 covers the exposed surfaces of the doped polysilicon layer 130 and the barrier layer 140. The electrode 150 penetrates the dielectric layer 170 and contacts the barrier layer 140. The dielectric layer 170 can be a laminated passivation film, which has a passivation effect on the solar cell, and the dielectric layer 170 can also be an anti-reflection film.

In FIG. 1, the barrier layer 140 is disposed on the surface of the doped polysilicon layer 130 away from the substrate 110 in the first direction D1. The electrode 150 is in contact with the barrier layer 140 through a firing process, thereby forming an electrical connection with the barrier layer 140 and the doped polysilicon layer 130 (there is an electrical connection between the doped polysilicon layer 130 and the barrier layer 140 due to their contact). In FIG. 1, the electrode 150 goes deep into the barrier layer 140 and does not go deep into the doped polysilicon layer 130. In some other embodiments, the electrode 150 can also penetrate through the barrier layer 140 and further go deep into the doped polysilicon layer 130.

The firing process has an ablation effect on the barrier layer 140 and the doped polysilicon layer 130, which results in the situation in which the electrode 150 burns through the doped polysilicon layer 130 and then contacts the substrate 110. The contact between the electrode 150 and the substrate 110 will cause the recombination current density in the electrode region to increase sharply, thereby causing the efficiency of the solar cell to decrease.

Embodiments of the present disclosure form the barrier layer 140 that is in contact with the doped polysilicon layer 130 in the electrode region (where the electrode 150 is fired). When firing the electrode 150, the doped polysilicon layer 130 will be ablated only after the electrode 150 burns through the barrier layer 140. Therefore, the barrier layer 140 reduces the risk of the electrode 150 burning through the doped polysilicon layer 130.

In one embodiment, the material of the barrier layer 140 is selected from materials that are more resistant to ablation than the doped polysilicon layer 130, such as silicon carbide and/or zinc oxide. Compared with polysilicon with a lower crystallization rate, polysilicon with a higher crystallization rate is more resistant to ablation. In some embodiments, the crystallization rate of the polysilicon in the barrier layer 140 is equal to or greater than 90%, and the crystallization rate of the doped polysilicon layer 130 is 80% to 95%. For example, the crystallization rate of the polysilicon in the barrier layer 140 maybe 90 %, 95%, 99%, or 100 %, and the crystallization rate of the doped polysilicon layer 130 may be 80%, 85%, 90 %, or 95%. In some embodiments, the crystallization rate of the polysilicon in the barrier layer 140 decreases as the distance from the substrate 110 in the first direction D1 decreases.

The material of the barrier layer 140 may also be a mixture of any two or more of silicon carbide, zinc oxide, and polysilicon.

The technical effect of "the barrier layer 140 can prevent the electrode 150 from burning through the doped polysilicon layer 130" is briefly described here. In FIG. 1, the barrier layer 140 is disposed on the surface of the doped polysilicon layer 130 away from the substrate 110, which increases the path length for the electrode 150 to burn through the doped polysilicon layer 130, thereby preventing the electrode 150 from burning through the doped polysilicon layer 130. Moreover, when the barrier layer 140 is selected from an ablation-resistant material, the barrier layer 140 can also prevent the electrode 150 from burning through the doped polysilicon layer 130 by its own ablation-resistant properties. In short, the barrier layer 140 can prevent the doped polysilicon layer 130 from being burned through by the electrode 150 by both aspects "increasing the burn-through path" and "its own ablation resistance properties". It should be understood that the barrier layer 140 can prevent the polysilicon layer 130 from being burned through by the electrode 150 through only one, instead of two of the above aspects.

In addition, the doped polysilicon layer 130 has optical parasitic effect, which reduces the utilization of incident light by the solar cell. Reducing the thickness of doped polysilicon layer 130 can reduce its absorption of incident light. However, the technical solution of reducing the thickness of the doped polysilicon layer 130 in the conventional technology has a side effect of increasing the risk of the electrode 150 burning through the tunnel oxide layer 120. The technical solution of setting the barrier layer 140 in the electrode region in the present disclosure increases the difficulty for the electrode 150 to burn through the doped polysilicon layer 130. Therefore, even if the thickness of the doped polysilicon layer 130 is reduced, it can be ensured that the electrode 150 does not burn through the doped polysilicon layer 130, which reduces the absorption of incident light by the doped polysilicon layer 130 and improves the solar cell's utilization rate of incident light. In some embodiments, the thickness of the doped polysilicon layer 130 is equal to or greater than 3nm and equal to or less than 200nm. For example, the thickness of the doped polysilicon layer 130 maybe 3nm, 10nm, 20nm, 30nm, 40nm, 50nm, 60nm, 70nm, 80nm, 90nm, 100nm, 110nm, 120nm, 130nm, 140nm, 150nm, 160nm, 170nm, 180nm, 190nm or 200nm. Since the thickness of the doped polysilicon layer 130 is equal to or greater than 3 nm, it can ensure the lateral transport capability of carriers and ensure that the field passivation of the substrate 110 meets the requirements. Here,the thickness of the doped polysilicon layer 130 refers to the dimension of the doped polysilicon layer 130 in the first direction D1.

In FIG. 1, the barrier layer 140 is disposed on the surface of the doped polysilicon layer 130 away from the substrate 110 in the first direction D1. In the present disclosure, the positional relationship between the barrier layer 140 and the doped polysilicon layer 130 is not limited to that shown in FIG. 1, which will be described next.

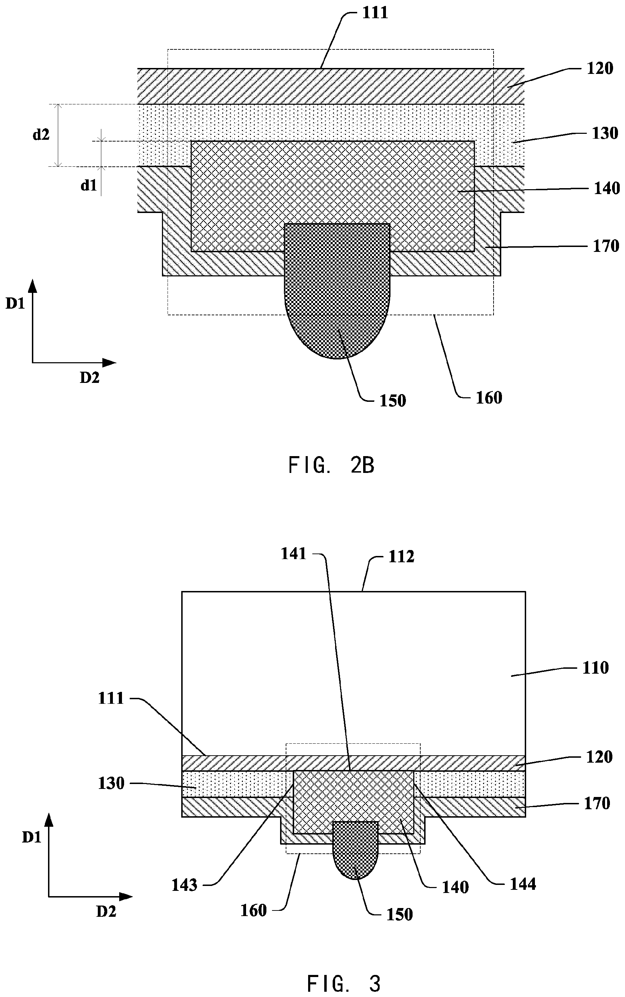

FIG. 2A is a schematic front view of a solar cell according to another embodiment, and FIG. 2B is an enlarged view of the partial structure in FIG. 2A. Referring to FIGs. 2A and 2B, the difference from FIG. 1 is that the barrier layer 140 in FIGs. 2A and 2B goes deep into in the doped polysilicon layer 130 with a predetermined depth d1 in the first direction D1. The predetermined depth d1 is equal to or less than the thickness d2 of the doped polysilicon layer 130. The present disclosure does not limit the predetermined depth d1, which can be 10 %, 20 %, 30 %, 40 %, 50 %, 60 %, 70%, 80 %, 90% or 100 % of the thickness d2. It should be understood that when the predetermined depth d1 is equal to the thickness d2 of the doped polysilicon layer 130, the bottom surface 141 of the barrier layer 140 is in contact with the surface of the tunnel oxide layer 120 away from the substrate 110 in the first direction D1. In other words, as shown in FIG. 3, the barrier layer 140 is disposed on the surface of the tunnel oxide layer 120 away from the substrate 110 in the first direction D1.

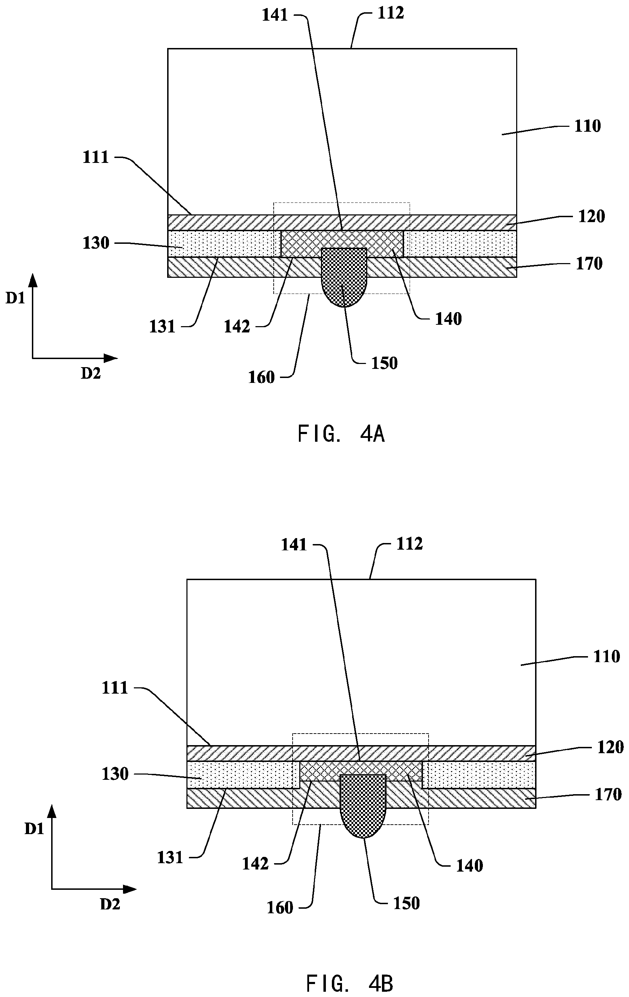

FIGs. 4A and 4B are schematic front views of solar cells in two embodiments. Referring to FIG. 4A, the barrier layer 140 is disposed on the surface of the tunnel oxide layer 120 away from the substrate 110 in the first direction D1, that is, the bottom surface 141 of the barrier layer 140 is in contact with the tunnel oxide layer 120. The barrier layer 140 has a top surface 142 away from the substrate 110 in the first direction D1, and the doped polysilicon layer 130 has a surface 131 away from the substrate 110 in the first direction D1. In FIG. 4A, the top surface 142 of the barrier layer 140 is flush with the surface 131 of the doped polysilicon layer 130. Referring to FIG. 4B, the difference between FIG. 4B and FIG. 4A is that the top surface 142 of the barrier layer 140 in FIG. 4B is closer to the substrate 110 than the surface 131 of the doped polysilicon layer 130. In some other embodiments, the top surface 142 may also be far away from the substrate 110 than the surface 131 in the first direction D, that is, the barrier layer 140 protrudes from the surface 131 away from the substrate 110.

In FIG. 1, the bottom surface 141 of the barrier layer 140 is in contact with the doped polysilicon layer 130. In FIGs. 2A to 4B, in addition to the bottom surface 141, the side surfaces of the barrier layer 140 are also in contact with the doped polysilicon layer 130. Taking FIG. 3 as an example, the barrier layer 140 has a first side 143 and a second side 144 opposite to each other in the second direction D2. The first side 143 and the second side 144 are both in contact with the doped polysilicon layer 130. Increasing the contact area between the barrier layer 140 and the doped polysilicon layer 130 is beneficial to reducing resistance.

In one embodiment, the recombination current density of the electrode region in FIGs. 1 to 4B is equal to or less than 100 fA/cm². Reducing the recombination current density helps to improve the efficiency of solar cells. A major factor in the recombination current density being equal to or less than 100 fA/cm² is that the electrode 150 does not burn through the doped polysilicon layer 130, thereby avoiding contact between the electrode 150 and the substrate 110. In some other embodiments, an ohmic contact is formed between the electrode 150 and the barrier layer 140, and the contact resistance between the two is equal to or less than 1 mohm·cm². The contact resistance can be adjusted by adjusting the doping concentration of the barrier layer 140, for example, increasing the doping concentration can reduce the contact resistance.

The solar cell in the above embodiments of the present disclosure is provided with a barrier layer in contact with the doped polysilicon layer in the electrode region, which reduces the risk of the electrode burning through the doped polysilicon layer. The thickness of the doped polysilicon layer can be further reduced, which reduces the absorption of incident light by the doped polysilicon layer and improves the utilization rate of incident light by the solar cell.

The present disclosure also includes a method for producing a solar cell, and the method will be described following.

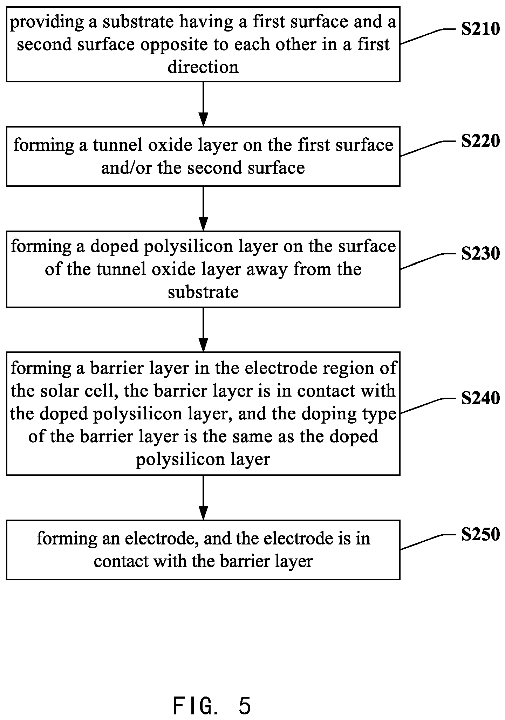

FIG. 5 is a flow chart of a method for producing a solar cell according to an embodiment. Referring to FIG. 5, the method according to the embodiment includes the following steps,
Step S210: providing a substrate having a first surface and a second surface opposite to each other in a first direction;
Step S220: forming a tunnel oxide layer on the first surface and/or the second surface;
Step S230: forming a doped polysilicon layer on the surface of the tunnel oxide layer away from the substrate;
Step S240: forming a barrier layer in the electrode region of the solar cell, wherein the barrier layer is in contact with the doped polysilicon layer, and the doping type of the barrier layer is the same as the doped polysilicon layer;
Step S250: forming an electrode, the electrode being in contact with the barrier layer.

Next, steps S210 to S250 will be described in detail.

Referring to FIG. 1, in step S210, a substrate 110 is provided. The substrate 110 has a first surface 111 and a second surface 112 opposite to each other in the first direction D1. In step S220, a tunnel oxide layer 120 is formed on the first surface 111. In some other embodiments, a tunnel oxide layer may be formed on the second surface 112, or a tunnel oxide layer may be formed on both the first surface 111 and the second surface 112. In step S230, a doped polysilicon layer 130 is formed on the surface of the tunnel oxide layer 120 away from the substrate 110 in the first direction D1. Methods for forming the tunnel oxide layer 120 and the doped polysilicon layer 130 include chemical vapor deposition (Chemical Vapor Deposition, CVD), physical vapor deposition (Physical Vapor Deposition, PVD), and thermal oxidation. For other descriptions about the substrate 110, the tunnel oxide layer 120, and the doped polysilicon layer 130, please refer to the relevant parts above and would not be elaborated here.

In one embodiment, the thickness of the doped polysilicon layer 130 is equal to or greater than 3nm and equal to or less than 200nm. For example, the thickness of the doped polysilicon layer 130 maybe 3nm, 10nm, 20nm, 30nm, 40nm, 50nm, 60nm, 70nm, 80nm, 90nm, 100nm, 110nm, 120nm, 130nm, 140nm, 150nm, 160nm, 170nm, 180nm, 190nm or 200nm. Since the thickness of the doped polysilicon layer 130 is equal to or greater than 3nm, it can ensure the lateral transmission capability of carriers and ensure that the field passivation of the substrate 110 meets the requirements.

Continuing to refer to FIG. 1, in step S240, a barrier layer 140 is formed in the electrode region of the solar cell. The barrier layer 140 is in contact with the doped polysilicon layer 130, and the doping type of the barrier layer 140 is the same with the doping type of the doped polysilicon layer 130. The doping type of the barrier layer 140 and the doping type of the doped polysilicon layer 130 may both be N-type or P-type.

In one embodiment, the method of forming the barrier layer 140 in FIG. 1 includes the following steps,
Step 11: cleaning the surface of the doped polysilicon layer 130. The surface includes a surface of the doped polysilicon layer 130 away from the substrate 110 in the first direction D1. The contaminants on the surface of the doped polysilicon layer 130 can be removed through the cleaning process.
Step 12: forming a barrier layer 140 in the electrode region, the barrier layer 140 is in contact with the surface of the doped polysilicon layer 130 away from the substrate 110 in the first direction D1.

The method of forming the barrier layer 140 in step 12 includes chemical vapor deposition and physical vapor deposition. The material of the barrier layer 140 includes one or more of silicon carbide, and zinc oxide.

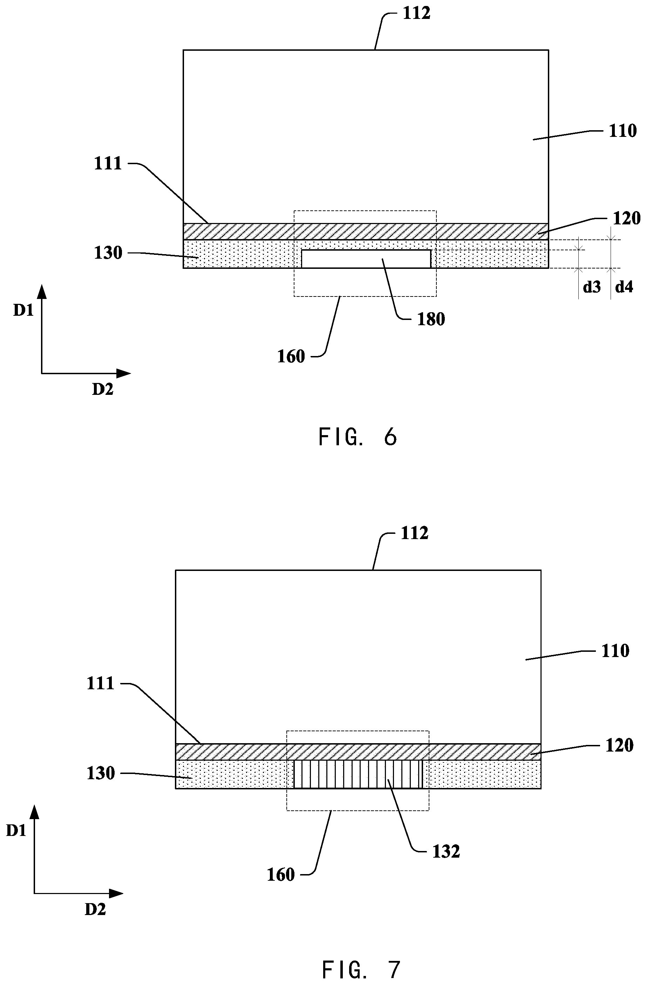

The intermediate products in the process of producing the solar cells are shown in FIGs. 2A, 2B, and 6. In one embodiment, the method of forming the barrier layer 140 in FIGs. 2A and 2B include the following steps:
Step 21: etching the doped polysilicon layer 130 in the electrode region in the first direction D1 to form a groove 180 with a predetermined depth d3.
Step 22: forming the barrier layer 140 in the groove 180, the predetermined depth d3 is equal to or less than the thickness d4 of the doped polysilicon layer 130.

The present disclosures do not limit the method of etching the doped polysilicon layer 130. For example, it may be physical etching or chemical etching. As shown in FIGs. 2A and 2B, the barrier layer 140 protrudes from the doped polysilicon layer 130 away from the substrate 110. In some other embodiments, the surface of the barrier layer 140 away from the substrate 110 may be flush with the surface of the doped polysilicon layer 130 away from the substrate 110.

As shown in FIG. 3 and FIG. 6, when the predetermined depth d3 is equal to the thickness d4 of the doped polysilicon layer 130, the barrier layer 140 formed in the groove 180 is in contact with the surface of the tunnel oxide layer 120 away from the substrate 110.

In one embodiment, the recombination current density of the electrode region is equal to or less than 100 fA/cm². Reducing the recombination current density helps improve the efficiency of solar cells.

Returning to FIG. 5, in step S250, an electrode is formed, and the electrode is in contact with the barrier layer. Taking FIG. 1 as an example for explanation, an electrode 150 is formed in contact with the barrier layer 140. An electrical connection is established between the barrier layer 140 and the electrode 150 through contact. The electrode 150 in contact with the barrier layer 140 may be formed by a firing method. This disclosure does not limit the depth of the electrode 150 into the barrier layer 140. In some embodiments, the electrode 150 may also penetrate the barrier layer 140, and further go deep into the doped polysilicon layer 130, but not penetrate the polysilicon layer 130.

Referring to FIG. 1, in some embodiments, a step is further included before step S250: forming a dielectric layer 170 covering a surface of the doped polysilicon layer 130 away from the substrate 110 and a surface of the barrier layer 140 away from the substrate 110. In step S250, the electrode 150 penetrates the dielectric layer 170 and goes deep into the barrier layer 140.

The producing method in the above embodiments of the present disclosure sets a barrier layer in contact with the doped polysilicon layer in the electrode region, which reduces the risk of the electrode burning through the doped polysilicon layer. The thickness of the doped polysilicon layer can be further reduced, which helps to reduce the absorption of incident light by the doped polysilicon layer and improve the utilization rate of incident light by the solar cell.

The basic concepts have been described above. Obviously, for those skilled in the art, the above disclosure disclosures are only examples and do not constitute limitations to the present disclosure. Although not explicitly stated herein, those skilled in the art may make various modifications, improvements, and corrections to this disclosure.

At the same time, this disclosure uses specific words to describe the embodiments of the disclosure. For example, "one embodiment", "an embodiment", and/or "some embodiments" means a certain feature, structure or characteristic related to at least one embodiment of the present disclosure. Therefore, it should be emphasized and noted that "one embodiment" or "an embodiment" or "an alternative embodiment" mentioned twice or more at different places in this specification does not necessarily refer to the same embodiment.. In addition, certain features, structures or characteristics in one or more embodiments of the present disclosure may be appropriately combined.

In some embodiments, numbers are used to describe the quantities of components and properties. It should be understood that such numbers used to describe the embodiments are modified by the modifiers "about", "approximately" or "substantially" in some examples. Grooming. Unless otherwise stated, "about", "approximately" or "substantially" means that the stated number is allowed to vary by ± 20%. Accordingly, in some embodiments, the numerical parameters used in the specification and claims are approximations that may vary depending on the desired features of the individual embodiment. In some embodiments, numerical parameters should account for the specified number of significant digits and use general digit preservation methods. Although the numerical fields and parameters used to confirm the breadth of the ranges in some embodiments of the present disclosure are approximations, in specific embodiments, such numerical values are set as accurately as feasible.

## Claims

1. A solar cell, comprising:
a substrate(110) having a first surface(111) and a second surface(112) opposite to each other in a first direction(D1), wherein the first direction(D1) is a thickness direction of the substrate(110);
a tunnel oxide layer(120) located on the first surface(111) and/or the second surface(112);
a doped polysilicon layer(130) located on a surface of the tunnel oxide layer(120) away from the substrate(110);
a barrier layer(140) located in an electrode region(160) of the solar cell and in contact with the doped polysilicon layer(130), wherein a doping type of the barrier layer(140) is the same as the doped polysilicon layer(130);
an electrode(150) located in the electrode region(160) and in contact with the barrier layer(140);
**characterized in that** a method of forming the barrier layer(140) includes etching the doped polysilicon layer(130) in the electrode region(150) in the first direction to form a groove(180) with a predetermined depth(d3), and forming the barrier layer(140) in the groove(180), wherein the predetermined depth(d3) is equal to or less than a thickness of the doped polysilicon layer(130), a material of the barrier layer(140) includes silicon carbide and/or zinc oxide.

2. The solar cell of claim 1, wherein the barrier layer goes deep into the doped polysilicon layer to the predetermined depth in the first direction.

3. The solar cell of claim 1, wherein the barrier layer is located on the surface of the tunnel oxide layer away from the substrate.

4. The solar cell of claim 3, wherein a surface of the barrier layer away from the substrate is flush with a surface of the doped polysilicon layer away from the substrate, or the surface of the barrier layer away from the substrate is closer to the substrate than the surface of the doped polysilicon layer away from the substrate, or the surface of the barrier layer away from the substrate is further away from the substrate than the surface of the doped polysilicon layer away from the substrate.

5. The solar cell of claim 1, wherein a recombination current density of the electrode region is equal to or less than 100fA/cm².

6. The solar cell of claim 1, further comprising a dielectric layer(170), wherein the dielectric layer is located on a surface of the doped polysilicon layer away from the substrate and a surface of the barrier layer away from the substrate.

7. The solar cell of claim 6, wherein the electrode penetrates the dielectric layer and contacts the barrier layer.

8. The solar cell according to claim 1, wherein the thickness of the doped polysilicon layer is equal to or greater than 3nm, and equal to or less than 200nm.

9. A method for producing a solar cell, comprising:
providing a substrate having a first surface and a second surface opposite to each other in a first direction, wherein the first direction is a thickness direction of the substrate;
forming a tunnel oxide layer on the first surface and/or the second surface;
forming a doped polysilicon layer on a surface of the tunnel oxide layer away from the substrate;
forming a barrier layer in an electrode region of the solar cell, wherein the barrier layer is in contact with the doped polysilicon layer, and a doping type of the barrier layer is the same as the doped polysilicon layer; and
forming an electrode in contact with the barrier layer;
**characterized in that** a method of forming the barrier layer includes etching the doped polysilicon layer in the electrode region in the first direction to form a groove with a predetermined depth, and forming the barrier layer in the groove, wherein the predetermined depth is equal to or less than a thickness of the doped polysilicon layer, and a material of the barrier layer includes silicon carbide and/or zinc oxide.

10. The method of claim 9, wherein a method of forming the barrier layer includes:
cleaning a surface of the doped polysilicon layer;
forming the barrier layer in the electrode region, wherein the barrier layer is in contact with a surface of the doped polysilicon layer away from the substrate.

11. The method of claim 9, wherein the recombination current density of the electrode region is equal to or less than 100fA/cm².

12. The method of claim 9, wherein the thickness of the doped polysilicon layer is equal to or greater than 3nm, and equal to or less than 200nm.

## Patentansprüche

1. Solarzelle, umfassend:
ein Substrat(110) mit einer ersten Oberfläche(111) und einer zweiten Oberfläche(112), die in einer ersten Richtung(D1) einander gegenüberliegen, wobei die erste Richtung(D1) eine Dickenrichtung des Substrats(110) ist;
eine Tunneloxidschicht(120), die auf der ersten Oberfläche(111) und/oder der zweiten Oberfläche(112) angeordnet ist;
eine dotierte Polysiliziumschicht(130), die auf einer Oberfläche der Tunneloxidschicht(120) weg vom Substrat(110) angeordnet ist;
eine Barriereschicht(140), die in einem Elektrodenbereich(160) der Solarzelle angeordnet ist und die dotierte Polysiliziumschicht(130) kontaktiert, wobei ein Dotierungstyp der Barriereschicht(140) derselbe wie der der dotierten Polysiliziumschicht(130) ist;
eine Elektrode(150), die im Elektrodenbereich(160) angeordnet ist und die Barriereschicht(140) kontaktiert;
**dadurch gekennzeichnet, dass** ein Verfahren zum Bilden der Barriereschicht(140) das Ätzen der dotierten Polysiliziumschicht(130) im Elektrodenbereich(150) in der ersten Richtung umfasst, um eine Rille(180) mit einer vorbestimmten Tiefe(d3) zu bilden, und das Bilden der Barriereschicht(140) in der Rille(180), wobei die vorbestimmte Tiefe(d3) gleich oder kleiner als eine Dicke der dotierten Polysiliziumschicht(130) ist, ein Material der Barriereschicht(140) Siliziumkarbid und/oder Zinkoxid umfasst.

2. Solarzelle nach Anspruch 1, wobei die Barriereschicht in der ersten Richtung bis zur vorbestimmten Tiefe tief in die dotierte Polysiliziumschicht eindringt.

3. Solarzelle nach Anspruch 1, wobei die Barriereschicht auf der Oberfläche der Tunneloxidschicht weg vom Substrat angeordnet ist.

4. Solarzelle nach Anspruch 3, wobei eine Oberfläche der Barriereschicht weg vom Substrat mit einer Oberfläche der dotierten Polysiliziumschicht weg vom Substrat bündig ist, oder die Oberfläche der Barriereschicht weg vom Substrat näher am Substrat ist als die Oberfläche der dotierten Polysiliziumschicht weg vom Substrat, oder die Oberfläche der Barriereschicht weg vom Substrat weiter vom Substrat entfernt ist als die Oberfläche der dotierten Polysiliziumschicht weg vom Substrat.

5. Solarzelle nach Anspruch 1, wobei eine Rekombinationsstromdichte des Elektrodenbereichs gleich oder kleiner als 100fA/cm² ist.

6. Solarzelle nach Anspruch 1, ferner umfassend eine dielektrische Schicht(170), wobei die dielektrische Schicht auf einer Oberfläche der dotierten Polysiliziumschicht weg vom Substrat und einer Oberfläche der Barriereschicht weg vom Substrat angeordnet ist.

7. Solarzelle nach Anspruch 6, wobei die Elektrode die dielektrische Schicht durchdringt und die Barriereschicht kontaktiert.

8. Solarzelle nach Anspruch 1, wobei die Dicke der dotierten Polysiliziumschicht gleich oder größer als 3nm und gleich oder kleiner als 200nm ist.

9. Verfahren zur Herstellung einer Solarzelle, umfassend:
Bereitstellen eines Substrats mit einer ersten Oberfläche und einer zweiten Oberfläche, die in einer ersten Richtung einander gegenüberliegen, wobei die erste Richtung eine Dickenrichtung des Substrats ist;
Bilden einer Tunneloxidschicht auf der ersten Oberfläche und/oder der zweiten Oberfläche;
Bilden einer dotierten Polysiliziumschicht auf einer Oberfläche der Tunneloxidschicht weg vom Substrat;
Bilden einer Barriereschicht in einem Elektrodenbereich der Solarzelle, wobei die Barriereschicht die dotierte Polysiliziumschicht kontaktiert und ein Dotierungstyp der Barriereschicht derselbe wie der der dotierten Polysiliziumschicht ist; und
Bilden einer Elektrode, die die Barriereschicht kontaktiert;
**dadurch gekennzeichnet, dass** ein Verfahren zum Bilden der Barriereschicht das Ätzen der dotierten Polysiliziumschicht im Elektrodenbereich in der ersten Richtung umfasst, um eine Rille mit einer vorbestimmten Tiefe zu bilden, und das Bilden der Barriereschicht in der Rille, wobei die vorbestimmte Tiefe gleich oder kleiner als eine Dicke der dotierten Polysiliziumschicht ist und ein Material der Barriereschicht Siliziumkarbid und/oder Zinkoxid umfasst.

10. Verfahren nach Anspruch 9, wobei ein Verfahren zum Bilden der Barriereschicht umfasst:
Reinigen einer Oberfläche der dotierten Polysiliziumschicht;
Bilden der Barriereschicht im Elektrodenbereich, wobei die Barriereschicht eine Oberfläche der dotierten Polysiliziumschicht weg vom Substrat kontaktiert.

11. Verfahren nach Anspruch 9, wobei die Rekombinationsstromdichte des Elektrodenbereichs gleich oder kleiner als 100fA/cm² ist.

12. Verfahren nach Anspruch 9, wobei die Dicke der dotierten Polysiliziumschicht gleich oder größer als 3nm und gleich oder kleiner als 200nm ist.

## Revendications

1. Cellule solaire, comprenant :
un substrat(110) ayant une première surface(111) et une deuxième surface(112) opposées l'une à l'autre dans une première direction(D1), où la première direction(D1) est une direction d'épaisseur du substrat(110) ;
une couche d'oxyde tunnel(120) située sur la première surface(111) et/ou la deuxième surface(112);
une couche de polysilicium dopé(130) située sur une surface de la couche d'oxyde tunnel(120) éloignée du substrat(110) ;
une couche barrière(140) située dans une région d'électrode(160) de la cellule solaire et en contact avec la couche de polysilicium dopé(130), où un type de dopage de la couche barrière(140) est le même que la couche de polysilicium dopé(130) ;
une électrode(150) située dans la région d'électrode(160) et en contact avec la couche barrière(140);
**caractérisé en ce qu'**un procédé de formation de la couche barrière(140) comprend la gravure de la couche de polysilicium dopé(130) dans la région d'électrode(150) dans la première direction pour former une rainure(180) avec une profondeur prédéterminée(d3), et la formation de la couche barrière(140) dans la rainure(180), où la profondeur prédéterminée(d3) est égale ou inférieure à une épaisseur de la couche de polysilicium dopé(130), un matériau de la couche barrière(140) comprend du carbure de silicium et/ou de l'oxyde de zinc.

2. Cellule solaire selon la revendication 1, dans laquelle la couche barrière pénètre dans la couche de polysilicium dopé jusqu'à la profondeur prédéterminée dans la première direction.

3. Cellule solaire selon la revendication 1, dans laquelle la couche barrière est située sur la surface de la couche d'oxyde tunnel éloignée du substrat.

4. Cellule solaire selon la revendication 3, dans laquelle une surface de la couche barrière éloignée du substrat est affleurante avec une surface de la couche de polysilicium dopé éloignée du substrat, ou la surface de la couche barrière éloignée du substrat est plus proche du substrat que la surface de la couche de polysilicium dopé éloignée du substrat, ou la surface de la couche barrière éloignée du substrat est plus éloignée du substrat que la surface de la couche de polysilicium dopé éloignée du substrat.

5. Cellule solaire selon la revendication 1, dans laquelle une densité de courant de recombinaison de la région d'électrode est égale ou inférieure à 100fA/cm².

6. Cellule solaire selon la revendication 1, comprenant en outre une couche diélectrique(170), où la couche diélectrique est située sur une surface de la couche de polysilicium dopé éloignée du substrat et une surface de la couche barrière éloignée du substrat.

7. Cellule solaire selon la revendication 6, dans laquelle l'électrode pénètre la couche diélectrique et est en contact avec la couche barrière.

8. Cellule solaire selon la revendication 1, dans laquelle l'épaisseur de la couche de polysilicium dopé est égale ou supérieure à 3nm, et égale ou inférieure à 200nm.

9. Procédé de fabrication d'une cellule solaire, comprenant :
la fourniture d'un substrat ayant une première surface et une deuxième surface opposées l'une à l'autre dans une première direction, où la première direction est une direction d'épaisseur du substrat ;
la formation d'une couche d'oxyde tunnel sur la première surface et/ou la deuxième surface ;
la formation d'une couche de polysilicium dopé sur une surface de la couche d'oxyde tunnel éloignée du substrat ;
la formation d'une couche barrière dans une région d'électrode de la cellule solaire, où la couche barrière est en contact avec la couche de polysilicium dopé, et un type de dopage de la couche barrière est le même que la couche de polysilicium dopé ; et
la formation d'une électrode en contact avec la couche barrière ;
**caractérisé en ce qu'**un procédé de formation de la couche barrière comprend la gravure de la couche de polysilicium dopé dans la région d'électrode dans la première direction pour former une rainure avec une profondeur prédéterminée, et la formation de la couche barrière dans la rainure, où la profondeur prédéterminée est égale ou inférieure à une épaisseur de la couche de polysilicium dopé, et un matériau de la couche barrière comprend du carbure de silicium et/ou de l'oxyde de zinc.

10. Procédé selon la revendication 9, dans lequel un procédé de formation de la couche barrière comprend :
le nettoyage d'une surface de la couche de polysilicium dopé ;
la formation de la couche barrière dans la région d'électrode, où la couche barrière est en contact avec une surface de la couche de polysilicium dopé éloignée du substrat.

11. Procédé selon la revendication 9, dans lequel la densité de courant de recombinaison de la région d'électrode est égale ou inférieure à 100fA/cm².

12. Procédé selon la revendication 9, dans lequel l'épaisseur de la couche de polysilicium dopé est égale ou supérieure à 3nm, et égale ou inférieure à 200nm.
